# EUROPÄISCHE PATENTSCHRIFT

(11) **EP 0 941 642 B1**
(45) Veröffentlichungstag und Bekanntmachung des Hinweises auf die Patenterteilung: **11.10.2000**
(21) Anmeldenummer: 97951095.5
(22) Anmeldetag: 25.11.1997
(51) Int. Cl.: H05K 7/10

(54) **SOCKEL FÜR EINE INTREGRIERTE SCHALTUNG**
BASE FOR AN INTEGRATED CIRCUIT
SUPPORT POUR CIRCUIT INTEGRE

(30) Priorität: 26.11.1996 DE 29620596 U
(43) Veröffentlichungstag der Anmeldung: 15.09.1999
(73) Patentinhaber: SIEMENS AKTIENGESELLSCHAFT, 80333 München (DE)
(72) Erfinder: KLEIN, Klaus, D-76287 Rheinstetten (DE)
(86) Internationale Anmeldenummer: DE9702756
(87) Internationale Veröffentlichungsnummer: WO9824283

(56) Entgegenhaltungen:
- EP-A- 0 376 659
- EP-A- 0 632 538
- US-A- 5 241 453
- US-A- 5 357 404

## Beschreibung

Die Erfindung betrifft einen Sockel für eine integrierte Schaltung nach dem Oberbegriff des Anspruchs 1.

Hochkomplexe und kostenintensive integrierte Schaltungen, z. B. Prozessoren, werden als Bauelemente in hochpoligen, standardisierten Gehäusen, z. B. PGA (Pin Grid Array) oder SPGA (Staggered Pin Grid Array), angeboten. Zur Montage auf einer Leiterplatte werden Anschlußelemente der integrierten Schaltung, sogenannte Pins, wahlweise durch Löten direkt mit Anschlußelementen der Leiterplatte verbunden oder die integrierte Schaltung wird lösbar in einen Sockel eingesetzt, der selbst auf die Leiterplatte gelötet ist und die elektrischen Verbindungen zwischen Anschlußelementen der integrierten Schaltung und Anschlußelementen der Leiterplatte herstellt. Mit dem höheren Aufwand bei der Verwendung eines Sockels als zusätzlichem Bauelement wird der Vorteil erreicht, daß ein späterer Austausch der integrierten Schaltung, z. B. zur Reparatur oder zur Aufrüstung mit einem leistungsfähigeren Bauelement, leicht durchgeführt werden kann. Bei direkt eingelöteter integrierter Schaltung wäre dieser nicht oder nur sehr aufwendig möglich.

Aus dem DE8716007U ist ein derartiger Sockel bekannt, der zusätzlich zur Kühlung der integrierten Schaltung mit einem Kühlkörper, der in einen Trägerrahmen eingeschnappt wird, ausgestattet ist. Besondere Maßnahmen zur elektromagnetischen oder elektrostatischen Abschirmung der integrierten Schaltung sind dort nicht beschrieben.

Aus der DE 39 22 461 C2 ist ein Abschirmgehäuse bekannt, das zur Unterbringung verschiedener Schaltungen verwendet werden kann. Das Gehäuse ist im wesentlichen quaderförmig und weist eine offene Seite auf, die, wenn es auf einer Leiterplatte montiert ist, durch diese verschlossen wird. Befestigt wird das Abschirmgehäuse an der Leiterplatte, indem vier an dem unteren Rand des Abschirmgehäuses ausgebildete Montagebeine in Montageöffnungen der Leiterplatte eingeführt und umgebogen oder verlötet werden. In dem Abschirmgehäuse untergebrachte Schaltungen werden direkt mit der Leiterplatte verlötet. Durch dieses Abschirmgehäuse wird ein ohnehin schon schwieriger Austausch eingesetzter Bauelemente in nachteiliger Weise zusätzlich erschwert. Ein weiterer Nachteil ist, daß sich die Kapselung der Bauelemente negativ auf die Entwärmung auswirkt, die insbesondere bei komplexen integrierten Schaltungen gewährleistet werden muß.

Der Erfindung liegt die Aufgabe zugrunde, einen Sockel für eine integrierte Schaltung zu schaffen, der trotz guter elektromagnetischer Abschirmung einen leichten Austausch eingesetzter integrierter Schaltungen ermöglicht.

Zur Lösung dieser Aufgabe weist der neue Sockel der eingangs genannten Art die im kennzeichnenden Teil des Anspruchs 1 angegebenen Merkmale auf. Vorteilhafte Weiterbildungen sind in den Unteransprüchen beschrieben.

Die Erfindung hat den Vorteil, daß die integrierte Schaltung bereits nach Öffnen des Gehäusedeckels zugänglich ist und aus einem Sockeleinsatz - eventuell unter Zuhilfenahme eines einfachen Aushebewerkzeuges - entnommen werden kann. Zum leichten Öffnen des Deckels kann dieser beispielsweise mit Schrauben, Klammern oder einer Rastverbindung befestigt werden. Die elektrische Anschlußtechnik des Sockeleinsatzes kann wie bei herkömmlichen Anschlußformen ausgeführt werden und unterliegt keinerlei zusätzlichen Beschränkungen. So können beispielsweise auf der Seite der integrierten Schaltung Anschlußelemente in Durchstecktechnik und auf der Leiterplattenseite die Anschlußelemente als BGA (Ball Grid Array) oder SGA (Stud Grid Array) ausgeführt werden. Insbesondere wenn auf der Leiterplattenseite eine SMD (Surface Mounted Device)-Anschlußtechnik eingesetzt wird, ist es vorteilhaft, den Sockeleinsatz in seiner Lage durch den Sockelrahmen, der auf der Leiterplatte befestigt ist, zu sichern. Dadurch wird vermieden, daß bei der Entnahme der integrierten Schaltung auftretende Ausziehkräfte auf die elektrischen Kontaktstellen des Sockeleinsatzes wirken und diese beschädigen. Auch bei einer Montage des Sockeleinsatzes in Einpreßtechnik sollten die Einpreßstifte nicht mit einer zu hohen Ziehkraft beansprucht werden. Durch eine Schräge an der Innenseite des Sockelrahmens kann eine leichte Zugänglichkeit der integrierten Schaltung für ein Aushebewerkzeug erreicht werden. Wird als Aushebewerkzeug beispielsweise ein Schraubendreher verwendet, so dient der Sockelrahmen in vorteilhafter Weise als nahe am Bauelement liegendes Gegenlager mit guter Hebelwirkung. Zusätzlich ist die Gestaltung des Sockelrahmens so ausgelegt, daß ein spezielles Aushebewerkzeug, welches auch zum Eindrücken des Bauelementes genutzt werden kann, einsetzbar ist. Durch einen aus mehreren Teilen zusammengesetzten Sockelrahmen können vorteilhaft verschiedene Rahmentypen nach einem Baukastenprinzip modular aufgebaut werden. Dies wirkt sich nicht negativ auf die Abschirmeigenschaften des Gehäuses bezüglich elektromagnetischer oder elektrostatischer Einflüsse aus, wenn sich die Teile an den Stoßstellen überlappen. Zur besseren Entwärmung können Deckel und Rahmen des Sockels als mit Kühlrippen versehene Kühlkörper ausgebildet werden.

Für einen guten Wärmekontakt zwischen Deckel und integrierter Schaltung liegt dieser formschlüssig, eventuell thermisch gekoppelt durch eine Wärmeleitpaste, auf der Oberseite der integrierten Schaltung auf. Auch zwischen Deckel und Rahmen ist die Verwendung einer Wärmeleitpaste vorteilhaft. Die bei der Entwärmung aktive Oberfläche kann weiter vergrößert werden, indem eine Bodenplatte auf der gegenüberliegenden Seite der Leiterplatte befestigt und mit Rahmen und Deckel des Gehäuses thermisch gekoppelt wird. Durch Zusatzmaßnahmen auf der Leiterplatte, z. B. großflächige Kupferflächen beidseitig, die mit möglichst vielen Durchkontaktierungen miteinander verbunden sind, können Wärmeübergang und Ground-Verbindung zusätzlich verbessert werden. Durch eine Ausnehmung in der Bodenplatte kann vorteilhaft sichergestellt werden, daß durch die Leiterplatte hindurchragende Anschlußelemente nicht kurzgeschlossen werden. Eine derartige Bodenplatte kann auch als Gegenlager bei der Montage eines Sockeleinsatzes mit Einpreßkontakten dienen. Bei BGA- oder SGA-Bauform des Sockeleinsatzes ist die Bodenplatte zur besseren Entwärmung und als Gegenlager vorteilhafter eben, d. h. ohne eine Ausnehmung, ausgeführt. Eine SMD-Anschlußtechnik auf der Leiterplattenseite hat zudem den Vorteil, daß auch integrierte Schaltungen mit PGA- oder SPGA-Anschlußformen, die eigentlich für eine Durchsteckmontage konzipiert sind, auf eine Leiterplatte in reiner SMD (Surface Mounted Device)-Technologie bestückt werden können, ohne daß hierbei das SMD-Prinzip durchbrochen werden muß. Mit diesem Sockel können integrierte Schaltungen für Durchsteckmontage auch bei Leiterplattentechnologien bestückt werden, die keine Durchkontaktierungen als Anschlußelemente zulassen. Dies ist beispielsweise bei Leiterplatten mit einer Mehrfach-Oberflächenverdrahtung der Fall, bei denen durch partielle Durchkontaktierungen zur Verbindung von Leitungen verschiedener Lagen die Anzahl der Signallagen drastisch reduziert wird. Durch die nun mögliche Anwendung einer reinen SMD-Technologie entfallen die Verfahrensschritte, die bei einer Mischtechnik zum Bestücken und Löten von Bauelementen in Durchsteckmontage erforderlich wären. D. h., eine Baugruppe muß im Herstellungsprozeß nicht mehr an einen Handbestückplatz und über ein Schwallbad geführt werden. Der Herstellungsaufwand ist somit erheblich verringert.

Anhand der Zeichnungen, die ein Ausführungsbeispiel der Erfindung darstellen, werden im folgenden die Erfindung sowie Ausgestaltungen und Vorteile näher erläutert.

Es zeigen:
- Figur 1: einen Sockel in Explosionsdarstellung,
- Figur 2: ein Schnittbild durch einen Sockel,
- Figur 3: einen Sockeleinsatz mit kraftschlüssiger Klemmung eines Kontaktelementes in einem Schnittbild,
- Figur 4: einen Sockeleinsatz mit formschlüssiger Klemmung,
- Figur 5: einen Sockeleinsatz mit kraft- und formschlüssiger Klemmung eines Kontaktelementes,
- Figur 6: einen Sockeleinsatz mit Anschlußelementen für Einpreßtechnik,
- Figur 7: einen Sockeleinsatz für Durchsteckmontage in Löttechnik und
- Figur 8: einen Sockeleinsatz in SGA-Ausführung.

Gleiche Teile sind mit gleichen Bezugszeichen versehen.

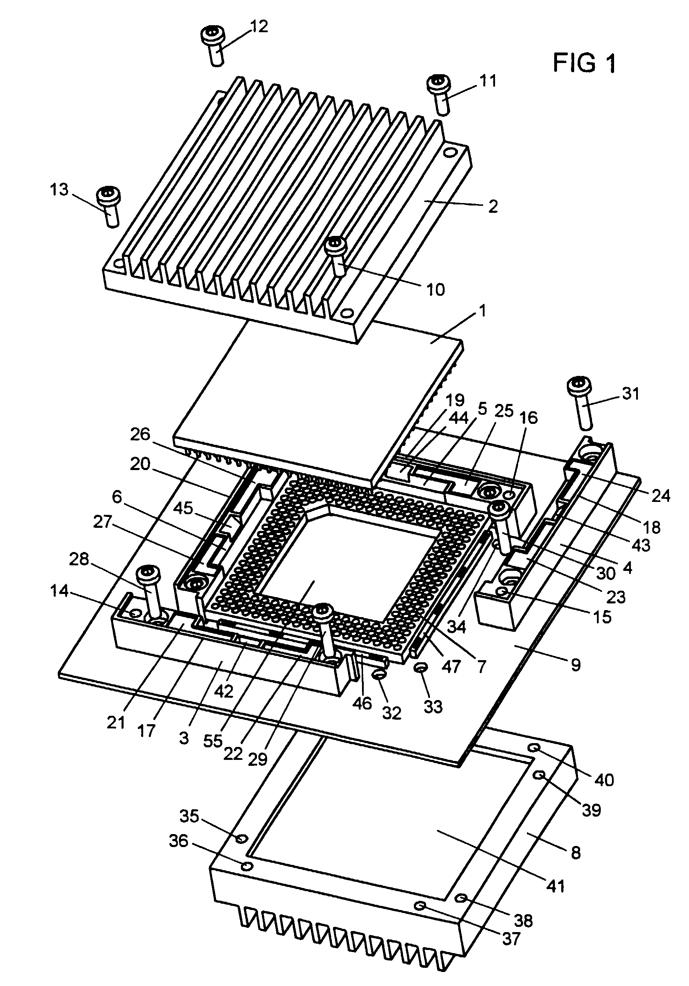

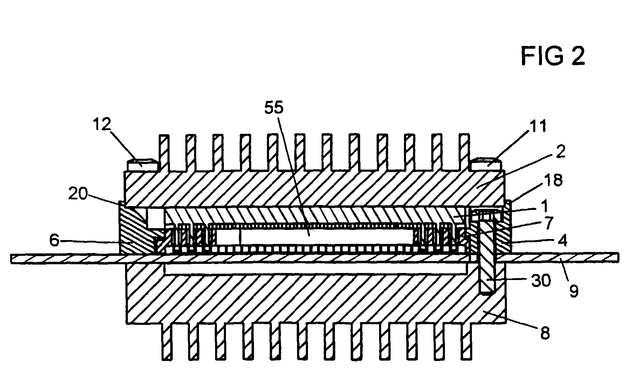

Gemäß Figur 1 besteht ein Sockel für eine integrierte Schaltung 1 im wesentlichen aus einem Deckel 2, einem hier aus vier Teilen 3, 4, 5 und 6 zusammengesetzten Rahmen, einem Sockeleinsatz 7 und einem Boden 8. Der Deckel 2 ist als Kühlkörper ausgeführt und mit Kühlrippen an seiner Oberseite versehen, so daß er entsprechend der Luftführung in dem Gerät, in welchem eine mit den gezeigten Bauteilen bestückte Leiterplatte 9 eingesetzt werden soll, optimal ausgerichtet werden kann. Befestigt wird der Deckel an dem Sockelrahmen mit vier im Bereich seiner Ecken angeordneten Schrauben 10 ... 13. Dazu sind in den Teilen 3 ... 6 des Sockelrahmens zu den Schrauben 10 ... 13 korrespondierende Öffnungen mit Innengewinde angebracht, von denen in Figur 2 nur die Öffnungen 14, 15 und 16 sichtbar sind. Damit das Abschirmgehäuse auch an den Stoßstellen zwischen dem Deckel 2 und dem Sockelrahmen strahlungsdicht ist, weisen die Teile 3 ... 6 jeweils einen Kragen 17, 18, 19 bzw. 20 auf, der den Deckel 2 an den zugeordneten Kantenabschnitten seitlich etwas überragt. Der Sockelrahmen kann aus wirtschaftlichen Gründen auch als einteiliger Rahmen mit weniger Befestigungspunkten auf der Leiterplatte ausgelegt werden. Im montierten Zustand liegt der Deckel 2 eben auf der Oberseite der integrierten Schaltung 1 auf. Dadurch wird bereits eine gute Wärmekopplung zwischen integrierter Schaltung 1 und Deckel 2 erreicht. Zur weiteren Verbesserung der Wärmekopplung kann die Oberseite der integrierten Schaltung 1 bei der Montage mit einer Wärmeleitpaste oder einem ähnlichen Mittel, z. B. Wärmeleitfolie, versehen werden. Um auch zwischen Sockelrahmen und Deckel 2 eine gute Wärmekopplung zu ermöglichen, sind in den Teilen 3 ... 6 jeweils zwei Ausnehmungen angebracht, die als Depot für Wärmeleitpaste dienen. In der Figur 1 sind von diesen lediglich die Ausnehmungen 21 ... 27 sichtbar. Die Teile 3 ... 6 des Sockelrahmens sind an den Stoßstellen mit Überlappungen versehen, damit auch über diese Stoßstellen keine elektromagnetischen oder elektrostatischen Einstreuungen das Abschirmgehäuse durchdringen können. Der Sockelrahmen wird mit acht Schrauben befestigt, die durch Öffnungen in der Leiterplatte geführt und in dazu korrespondierende Bohrungen mit Innengewinde im Boden 8 eingedreht werden. In Figur 1 sind lediglich die Schrauben 28 ... 31, die Öffnungen 32, 33 und 34 sowie Bohrungen 35 ... 40 dargestellt. Der Boden 8 ist ebenfalls als Kühlkörper ausgebildet und mit Kühlrippen versehen. An seiner Oberseite weist er eine Ausnehmung 41 auf, in welche an der Unterseite der Leiterplatte 9 eventuell überstehende Anschlußelemente des Sockeleinsatzes 7 hineinragen können, ohne den Boden 8 zu berühren. Der Boden 8 kann auch als Support oder Gegenlager benutzt werden, wenn ein Sockeleinsatz 7 mit Einpreßstiften verwendet wird oder mit Kontaktelementen, die durch Andrücken des Sockeleinsatzes 7 gegen die Leiterplatte 9 in ihren Führungen verklemmt werden. Wenn die Wärmekopplung zwischen Boden 8 und Sockelrahmen über die acht Befestigungsschrauben und die Kontaktstellen an der Leiterplatte 9 hinweg noch nicht ausreicht, können auf der Oberseite der Kanten des Bodens 8 wie auch auf der Unterseite der Teile 3 ... 6 des Sockelrahmens weitere, in Figur 1 nicht dargestellte Ausnehmungen als Depot für Wärmeleitpaste angebracht werden. Da auf beiden Seiten der Leiterplatte 9 Kühlkörper vorgesehen sind, wird die Gesamtbauhöhe des Sockels quasi auf beide Seiten der Leiterplatte 9 verteilt. Somit wird auf jeder Seite nur eine geringe Bauhöhe über der Leiterplatte 9 zur Realisierung der Entwärmung der integrierten Schaltung 1 benötigt. In bestimmten Fällen kann dies von entscheidender Bedeutung sein, beispielsweise wenn auf der Bestückseite der Leiterplatte 9 nur eine geringe Bauhöhe zulässig ist, die zur Entwärmung mit nur einem Kühlkörper auf der Bestückseite im lüfterlosen Betrieb nicht ausreichen würde. Für eine leichte Entnehmbarkeit der integrierten Schaltung 1, z. B. zur Reparatur oder Aufrüstung des elektronischen Geräts, sind an den Teilen 3 ... 6 des Sockelrahmens schräg verlaufende Ausnehmungen 42, 43, 44 bzw. 45 vorhanden, in welche ein Aushebewerkzeug, beispielsweise eine Schraubendreherklinge, derart eingeführt werden kann, daß es die Unterseite der integrierten Schaltung 1 hintergreift. Gleichzeitig dienen die Teile 3 ... 6 eventuell als Gegenlager, um eine Hebelwirkung zu erzeugen. Zur Lagesicherung des Sockeleinsatzes 7, d. h. damit dieser beim Ausziehen der integrierten Schaltung 1 nicht von der Leiterplatte 9 gelöst wird, sind an den Teilen 3 ... 6 des Sockelrahmens jeweils Stege, die in der Figur 1 verdeckt sind, vorgesehen, welche im montierten Zustand auf den Sockeleinsatz 7 nahezu völlig umlaufenden Kanten - in Figur 1 sind lediglich die Kanten 46 und 47 sichtbar - zu liegen kommen.

In Figur 2, einem Schnittbild durch einen montierten Sockel nach Figur 1, ist besonders gut die oben beschriebene Überlappung der Kragen 18 und 20 von Teilen 4 bzw. 6 des Sockelrahmens an den Seiten des Deckels 2 sichtbar. Deutlich wird auch die Verteilung der Gesamtbauhöhe des Sockels auf beide Seiten der Leiterplatte 9, wodurch eine jeweils niedrige Höhe auf Ober- und Unterseite bei guter Entwärmung der integrierten Schaltung 1 erreicht wird. Durch im Bereich des Sockelrahmens plazierte Kontaktstellen auf der Leiterplatte 9 kann der Sockelaufbau in das Ground-Konzept, d. h. die Führung der Schirm- und Bezugsmasse im elektronischen Gerät, eingebunden werden.

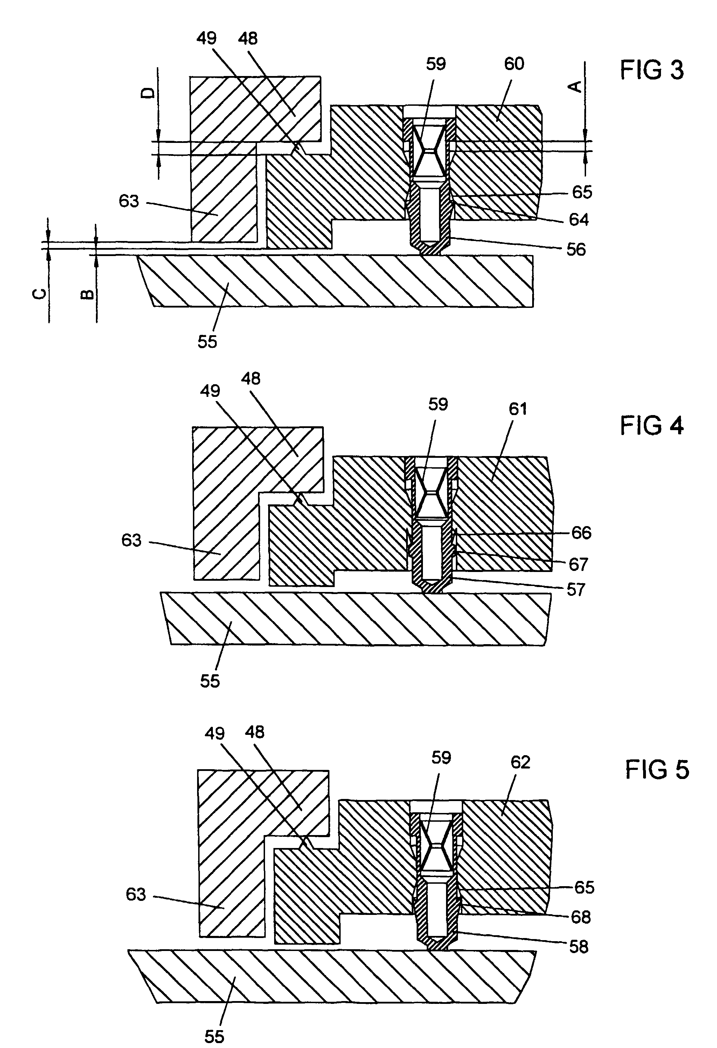

Die Figuren 3, 4 und 5 verdeutlichen verschiedene Varianten zur Klemmung eines Kontaktelementes im Sockeleinsatz nach dem Andrücken auf eine Leiterplatte 55. Dargestellt ist jeweils die Situation unmittelbar vor einem Andrücken. Kontaktelemente 56, 57 bzw. 58 sind jeweils mit einer Kontaktfeder 59 zur Kontaktierung des Anschlußelements einer einzusetzenden integrierten Schaltung versehen. In einen Kunststoffkörper 60, 61 oder 62 werden die Kontaktelemente 56, 57 bzw. 58 von oben eingesetzt und durch eine Rastverbindung in ihrer Endlage gegen ein Herausfallen gesichert. Auf die Leiterplatte 55 angedrückt und dort befestigt werden die Kunststoffkörper 60, 61 und 62 jeweils mit einem Rahmen 63, der direkt auf der Leiterplatte befestigbar ist. Zur Erläuterung des Toleranzausgleichs sind in Figur 3 Maße A, B, C und D eingezeichnet. Um das Maß A sind die Kontaktelemente 56, 57 und 58 bei allen drei Varianten einer Klemmung in ihren Führungen verschiebbar, um Höhentoleranzen der Anschlußelemente auf der Leiterplatte 55 ausgleichen zu können. Das Maß B bestimmt den Weg, um welchen die Kontaktelemente 56, 57 und 58 beim Andrücken der Sockeleinsätze gegen die Leiterplatte 55 aus ihrer Endlage im Kunststoffkörper 60, 61 bzw. 62 verschoben werden, um eine Klemmwirkung in der Führung zu erzeugen. Zur Lagesicherung des Sockeleinsatzes im Sockel ist am Rahmen 63 ein Steg 48 angebracht, dessen Unterseite auf der Oberseite einer Kante der Kunststoffkörper 60, 61 bzw. 62 der Sockeleinsätze aufliegt. Zum Ausgleich von Fertigungstoleranzen sowie zur Erzeugung einer definierten Andruckkraft sind an der Oberseite der Kante der Kunststoffkörper 60, 61 und 62 jeweils nach oben weisende, dachkantförmige Fortsätze 49 vorgesehen. Beim Andrücken der Sockeleinsätze gegen die Leiterplatte 55 wird die Höhe D der Fortsätze um das Maß C zum Toleranzausgleich durch eine Verformung der Fortsätze verringert. In der Variante gemäß Figur 3 wird eine kraftschlüssige Klemmung des Kontaktelements 56 im Kunststoffkörper 60 erreicht, indem sich beim Andrücken ein umlaufender Kragen 64 des Kontaktelements 56 in eine konusförmige Schräge 65 des Kunststoffkörpers 60 hineindrückt und dort durch gegenseitiges Verklemmen gehalten wird. Eine formschlüssige Klemmung ergibt sich bei der Variante nach Figur 4, bei welcher ein zunächst hohlkegelförmiger Kragen 66 am Schaft des Kontaktelements 57 anliegt und beim Andrücken gegen die Leiterplatte 55 durch einen umlaufenden Kragen 67 des Kontaktelements 57 deformiert wird. Dadurch wird in dem Kunststoffteil 61 eine formschlüssige Verbindung zum Kragen 67 gebildet. Bei der in Figur 5 dargestellten dritten Variante ist das Kontaktelement 58 mit einem umlaufenden, deformierbaren Spitzkragen 68 versehen, der sich in das Kunststoffteil 62 hineindrückt und eine formschlüssige sowie kraftschlüssige Klemmung bewirkt. Bei allen drei in den Figuren 3, 4 und 5 dargestellten Varianten ist somit sichergestellt, daß beim Ausziehen einer integrierten Schaltung 1, die als PGA- oder SPGA-Bauelement ausgeführt sein kann, keine Kräfte auf die Lötstellen an der Leiterplatte 55 wirken.

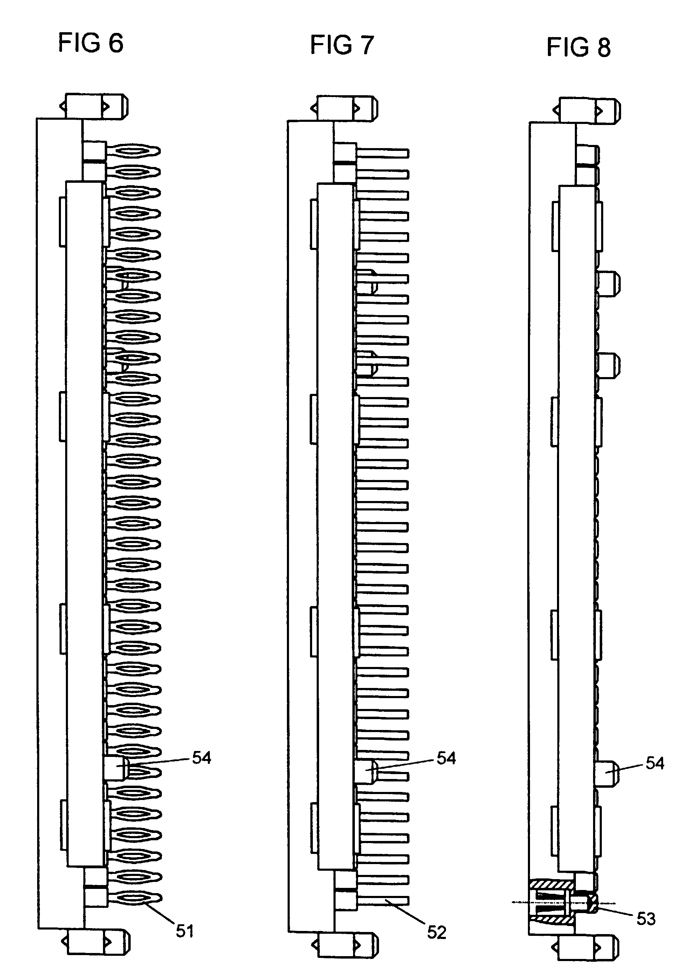

Ein Sockeleinsatz für eine Montage in Einpreßtechnik weist gemäß Figur 6 Einpreßstifte 51 mit Federelementen in ihrem Schaftbereich auf, die sich beim Einpressen in eine durchgehend metallisierte Bohrung einer Leiterplatte an die Innenseite der Bohrung andrücken. Eine Lötverbindung ist hierzu nicht erforderlich. Dagegen werden bei einem Sockel für Durchsteckmontage gemäß Figur 7 durch die metallisierten Öffnungen der Leiterplatte hindurchragende Anschlußstifte 52 durch Löten elektrisch mit Leiterbahnen der Leiterplatte verbunden. Auch Anschlußelemente 53 des in Figur 8 dargestellten Sockeleinsatzes werden an Anschlußflächen der Leiterplatte angelötet, die sich jedoch hier lediglich auf der Oberfläche der Leiterplatte befinden. Bei der hier verwendeten SMT (Surface Mounted Technology) ist es vorteilhaft, wenn der Sockeleinsatz durch Zentrierstifte 54, zu denen die Leiterplatte korrespondierende Bohrungen aufweist, vor dem Lötvorgang exakt positioniert wird. Auch bei den Ausführungsformen gemäß den Figuren 6 und 7 sind derartige Zentrierstifte hilfreich. Für einen Toleranzausgleich können bei der SGA-Ausführung gemäß Figur 8 oder einer BGA-Ausführung die Anschlußelemente 53 in Steckrichtung der Zentrierstifte 54 schwimmend gelagert sein. Durch entsprechende Gestaltung der Anschlußelemente und des Sockeleinsatzes kann dieser nach dem Lötprozeß durch den Sockelrahmen oder ein anderes Werkzeug auf die Leiterplatte gepreßt werden. Z. B. durch Klemmwirkung können die Anschlußelemente kraftschlüssig in ihrer Endlage im Sockeleinsatz zusätzlich befestigt werden. Ziehkräfte wirken danach nicht mehr auf die Lötanschlüsse.

Da durch das Abschirmgehäuse des Sockels und eventuell durch eine Masselage in der Leiterplatte eine in bezug auf elektromagnetische und elektrostatische Einflüsse hermetisch dicht abgeschlossene "Insel" gebildet wird, die wahlweise in ein Ground-Konzept fest eingebunden oder auch induktiv oder kapazitiv angekoppelt werden kann, lassen sich bei einer geänderten Formgebung mit vergrößertem Innenraum des Sockels oder im Freiraum 55 innerhalb des Sockeleinsatzes 7 weitere bezüglich elektromagnetischer Abschirmung kritische Bauelemente, z. B. Quarze, VCO- oder Taktschaltungen, in das Abschirmgehäuse integrieren. Dies ist besonders günstig bei Bauelementen, die der integrierten Schaltung funktionell zugeordnet sind.

Zur Vermeidung zu hoher Ausziehkräfte bei der Entnahme der integrierten Schaltung 1 können Sockeleinsätze verwendet werden, die auf der Seite der integrierten Schaltung als ZIF (Zero Insertion Force)- oder LIF (Low Insertion Force)-Version ausgeführt sind.

In vorteilhafter Weise kann der Sockel bei Austausch lediglich des Sockeleinsatzes 7 für integrierte Schaltungen unterschiedlicher Gehäusebauformen und unterschiedlicher elektrischer Anschlußelemente verwendet werden.

## Patentansprüche

1. Sockel für eine integrierte Schaltung, der zur Montage auf einer Leiterplatte geeignet und mit einem Sockeleinsatz (7) versehen ist, durch den elektrische Verbindungen zwischen Anschlußelementen der integrierten Schaltung (1) und Anschlußelementen der Leiterplatte (9) herstellbar sind, und der ein zur Leiterplatte (9) hin einseitig offenes Abschirmgehäuse mit einem Rahmen (3 ... 6) und einem Deckel (2) zur Aufnahme der integrierten Schaltung (1) und des Sockeleinsatzes (7) aufweist, wobei der Deckel (2) zur Entnahme der integrierten Schaltung (1) geöffnet werden kann, dadurch gekennzeichnet, daß der Sockelrahmen (3 ... 6) auf der Leiterplatte (9) befestigbar ist und daß der Sockelrahmen zur Lagesicherung des Sockeleinsatzes auf seiner Innenseite mit einem im wesentlichen umlaufenden Steg (48) versehen ist, an dessen Unterseite im montierten Zustand die Oberseite einer dazu korrespondierenden umlaufenden Kante (46, 47) des Sockeleinsatzes (7) anliegt.

2. Sockel nach Anspruch 1, **dadurch gekennzeichnet,** daß zur Befestigung des Sockelrahmens an der Leiterplatte Schrauben (28 ... 31) vorgesehen sind.

3. Sockel nach Anspruch 1 oder 2, **dadurch gekennzeichnet,** daß der Sockelrahmen an seiner Innenseite mit zumindest einer Ausnehmung (42 ... 45), insbesondere einer Schräge, versehen ist, die für ein Aushebewerkzeug, insbesondere einen Schraubendreher, einen Zugriff zum Ausheben der integrierten Schaltung (1) ermöglicht.

4. Sockel nach einem der vorhergehenden Ansprüche, **dadurch gekennzeichnet,** daß der Sockelrahmen rechteckig aus mehreren sich jeweils im wesentlichen entlang der geraden Kanten erstreckenden Teilen (3 ... 6) zusammengesetzt ist, wobei die Teile an den Stoßstellen, die sich im Bereich der Rahmenecken befinden, einander überlappen.

5. Sockel nach einem der vorhergehenden Ansprüche, **dadurch gekennzeichnet,** daß der Deckel (2) als mit Kühlrippen versehener Kühlkörper für die integrierte Schaltung ausgebildet ist.

6. Sockel nach Anspruch 5, **dadurch gekennzeichnet,** daß der Sockelrahmen als mit Kühlrippen versehener Kühlkörper ausgebildet ist.

7. Sockel nach Anspruch 5 oder 6, **dadurch gekennzeichnet,** daß der Sockelrahmen an den Auflageflächen des Deckels Kammern (21 ... 27) für Wärmeleitpaste zur thermischen Kopplung von Rahmen und Deckel aufweist.

8. Sockel nach einem der vorhergehenden Ansprüche, **dadurch gekennzeichnet,** daß Sockelrahmen und Deckel an den Stoßstellen einander überlappen.

9. Sockel nach einem der vorhergehenden Ansprüche, **dadurch gekennzeichnet,** daß eine Bodenplatte (8) zur Montage auf der dem Rahmen und dem Deckel gegenüberliegenden Seite der Leiterplatte (9) vorgesehen ist.

10. Sockel nach Anspruch 9, **dadurch gekennzeichnet,** daß die Bodenplatte (8) als mit Kühlrippen versehener Kühlkörper ausgebildet und im montierten Zustand durch Ausnehmungen (32, 33, 34) der Leiterplatte hindurch über den Sockelrahmen und/oder den Sockeldeckel mit der integrierten Schaltung wärmegekoppelt ist.

11. Sockel nach Anspruch 9 oder 10, **dadurch gekennzeichnet,** daß er durch Einklemmen der Leiterplatte zwischen Sockelrahmen und Bodenplatte befestigbar ist.

12. Sockel nach Anspruch 11, **dadurch gekennzeichnet,** daß Sockelrahmen und Bodenplatte mit durch die Leiterplatte ragenden Schrauben (28 ... 31) zusammenschraubbar sind.

13. Sockel nach einem der Ansprüche 9 bis 12, **dadurch gekennzeichnet,** daß die Bodenplatte eine Ausnehmung (41) für durch die Leiterplatte hindurchragende Anschlußelemente des Sockeleinsatzes (7) aufweist.

## Claims

1. Base for an integrated circuit, which is suitable for assembly on a printed board and is provided with a base insert (7), by means of which electrical connections between connection elements of the integrated circuit (1) and connection elements of the printed board (9) can be made, and which has a shield housing, open on one side towards the printed board (9), with a frame (3 ... 6) and a cover (2) to receive the integrated circuit (1) and the base insert (7), with the cover (2) being able to be opened for the removal of the integrated circuit (1), characterized in that the base frame (3 ... 6) can be secured on the printed board (9) and in that the base frame is provided on its inner side with a substantially circumferential bar (48) to secure the position of the base insert, the underside of which bar in the assembled state is abutted by the upper side of a corresponding circumferential edge (46, 47) of the base insert (7).

2. Base according to claim 1, characterized in that screws (28 ... 31) are provided to fasten the base frame to the printed board.

3. Base according to claim 1 or 2, characterized in that the base frame is provided on its inner side with at least one recess (42 ... 45), in particular a bevel, which enables access for a lifting tool, in particular a screwdriver, to lift the integrated circuit (1) out.

4. Base according to one of the preceding claims, characterized in that the base frame is composed in a rectangular manner of several parts (3 ... 6) each extending substantially along the straight edges, with the parts overlapping each other at the joint locations which are in the region of the frame corners.

5. Base according to one of the preceding claims, characterized in that the cover (2) is constructed as a cooling body, provided with cooling ribs, for the integrated circuit.

6. Base according to claim 5, characterized in that the base frame is constructed as a cooling body provided with cooling ribs.

7. Base according to claim 5 or 6, characterized in that the base frame has at the bearing surfaces of the cover chambers (21 ... 27) for heat-conducting paste for the thermal coupling of the frame and the cover.

8. Base according to one of the preceding claims, characterized in that the base frame and the cover overlap each other at the joint locations.

9. Base according to one of the preceding claims, characterized in that a floor plate (8) is provided for assembly on the side of the printed board (9) opposite the frame and the cover.

10. Base according to claim 9, characterized in that the floor plate (8) is constructed as a cooling body provided with cooling ribs and in the assembled state is thermally coupled to the integrated circuit through recesses (32, 33, 34) of the printed board by way of the base frame and/or the base cover.

11. Base according to claim 9 or 10, characterized in that it can be secured by way of clamping the printed board in between the base frame and the floor plate.

12. Base according to claim 11, characterized in that the base frame and the floor plate can be screwed together by screws (28 ... 31) projecting through the printed board.

13. Base according to one of claims 9 to 12, characterized in that the floor plate has a recess (41) for connection elements of the base insert (7) which project through the printed board.

## Revendications

1. Douille pour un circuit intégré qui convient au montage sur une plaquette à circuit imprimé et qui est munie d'un insert (7) de douille par lequel des liaisons électriques entre des éléments de raccordement du circuit (1) intégré et des éléments de raccordement de la plaquette (9) à circuit imprimé peuvent être produits, et qui comporte un boîtier de blindage qui est ouvert d'un côté en direction de la plaquette (9) à circuit imprimé et qui comporte un cadre (3...6) et un couvercle (2) pour la réception du circuit (1) intégré et de l'insert (7) de douille, le couvercle (2) pouvant être ouvert pour retirer le circuit (1) intégré, caractérisée en ce que le cadre (3...6) de douille peut être fixé sur la plaquette (9) à circuit imprimé et en ce que le cadre de douille est muni sur sa face intérieure, pour le blocage en position de l'insert de douille, d'une barrette (48) qui fait sensiblement le tour et à la face inférieure de laquelle s'applique, à l'état monté, la face supérieure d'un bord (46, 47), qui y correspond et qui fait le tour, de l'insert (7) de douille.

2. Douille suivant la revendication 1, caractérisée en ce qu'il est prévu des vis (28...31) pour la fixation du cadre de la douille à la plaquette à circuit imprimé.

3. Douille suivant la revendication 1 ou 2, caractérisée en ce que le cadre de douille est muni sur sa face intérieure d'au moins un évidement (42...45), notamment d'un biseau, qui permet à un outil pour enlever, notamment à un tournevis, un accès pour enlever le circuit (1) intégré.

4. Douille suivant l'une des revendications précédentes, caractérisée en ce que le cadre de douille est composé rectangulairement de plusieurs parties (3...6) qui s'étendent sensiblement le long des bords rectilignes, les parties se chevauchant l'une l'autre aux points de jonction, qui se trouvent dans la zone des angles du cadre.

5. Douille suivant l'une des revendications précédentes, caractérisée en ce que le couvercle (2) est réalisé en radiateur munis de nervures de refroidissement pour le circuit intégré.

6. Douille suivant la revendication 5, caractérisée en ce que le cadre de douille est réalisé en radiateur munis de nervures de refroidissement.

7. Douille suivant la revendication 5 ou 6, caractérisée en ce que le cadre de douille comporte sur les surfaces de support du couvercle des chambres (21...27) pour de la pâte thermoconductrice servant au couplage thermique du cadre et du couvercle.

8. Douille suivant l'une des revendications précédentes, caractérisée en ce que le cadre de douille et le couvercle se chevauchent l'un l'autre aux points de jonction.

9. Douille suivant l'une des revendications précédentes, caractérisée en ce qu'il est prévu une plaque (8) de fond pour le montage sur la face de la plaquette (9) à circuit imprimé faisant face au cadre et au couvercle.

10. Douille suivant la revendication 9, caractérisée en ce que la plaque (8) de fond est réalisée en radiateur munis de nervures de refroidissement et, à l'état monté, est thermocouplée au circuit intégré au travers d'évidements (32, 33, 34) de la plaquette à circuit imprimé, par l'intermédiaire du cadre de douille et/ou du couvercle de douille.

11. Douille suivant la revendication 9 ou 10, caractérisée en ce qu'il peut être fixé en serrant la plaquette à circuit imprimé entre le cadre de douille et la plaque de fond.

12. Douille suivant la revendication 11, caractérisée en ce que le cadre de douille et la plaque de fond peuvent être vissés l'un à l'autre par des vis (28...31) faisant saillie de la plaquette à circuit imprimé.

13. Douille suivant l'une des revendications 9 à 12, caractérisée en ce que la plaque de fond comporte un évidement (41) pour des éléments de raccordement de l'insert (7) de douille traversant la plaquette à circuit imprimé.
